# EUROPÄISCHE PATENTSCHRIFT

(11) **EP 3 818 562 B1**
(45) Veröffentlichungstag und Bekanntmachung des Hinweises auf die Patenterteilung: **06.05.2026**
(21) Anmeldenummer: 19739950.4
(22) Anmeldetag: 03.07.2019
(51) Int. Cl.: H01L 23/367, F28D 15/02, H01L 23/467, H01L 21/48, H05K 7/20

(54) **VERFAHREN ZUR HERSTELLUNG EINER LEISTUNGSMODULEINHEIT, LEISTUNGSMODULEINHEIT, NETZTEIL UND FREQUENZUMRICHTER**
POWER MODULE UNIT, METHOD FOR PRODUCING A POWER MODULE UNIT, POWER SUPPLY AND FREQUENCY CONVERTER
PROCÉDÉ DE FABRICATION D'UNE UNITÉ DE MODULE DE PUISSANCE, UNITÉ DE MODULE DE PUISSANCE, BLOC D'ALIMENTATION ET CONVERTISSEUR DE FRÉQUENCE

(30) Priorität: 12.09.2018 EP 18194020
(43) Veröffentlichungstag der Anmeldung: 12.05.2021
(73) Patentinhaber: Siemens Aktiengesellschaft, 80333 München (DE)
(72) Erfinder: KAPPAUF, Daniel, 91322 Gräfenberg (DE); PANICERSKI, Stanislav, 90449 Nürnberg (DE); SCHMENGER, Jens, 91301 Forchheim (DE); GOSPOS, Robert, 91054 Buckenhof (DE); KNEUER, Christian, 90766 Fürth (DE); NÄHRIG, Matthias, 91315 Höchstadt an der Aisch, Bayern (DE)
(74) Vertreter: Siemens Patent Attorneys
(86) Internationale Anmeldenummer: PCT/EP2019/067881
(87) Internationale Veröffentlichungsnummer: WO 2020/052829

(56) Entgegenhaltungen:
- EP-A1- 2 031 332
- EP-A1- 2 328 172
- EP-A1- 3 190 371
- EP-A2- 1 378 940
- DE-A1- 102006 038 980
- US-A1- 2012 112 201

## Beschreibung

Die Erfindung betrifft ein Verfahren zur Herstellung einer Leistungsmoduleinheit sowie eine Leistungsmoduleinheit. Darüber hinaus betrifft die Erfindung ein Netzteil und einen Frequenzumrichter.

Leistungsmodule umfassen in der Regel ein Substrat mit einem Leistungshalbleiter, beispielsweise einem IGBT (Insulated-Gate Bipolar Transistor), welcher auf einem Substrat fest verbunden ist. Das Substrat weist auf beiden Seiten eine Metallstruktur auf, wobei die Metallstruktur auf der einen Seite zur Verbindung mit dem Leistungshalbleiter ausgebildet ist und auf der anderen Seite auf einer Grundplatte befestigbar ist.

Die Grundplatte wird gemäß derzeitigem Stand der Technik vorzugsweise mit einer wärmeleitenden Struktur beaufschlagt und auf einem Kühlkörper befestigt. Um thermische Effekte auszugleichen, ist eine komplexe Vorbiegung der Grundplatte notwendig, so dass die Grundplatte auch bei einer Temperatur von mehr als 100 Grad Celsius fest mit dem Kühlkörper verbunden ist.

EP2328172 A1, EP3190371 A1, EP2031332 A1, EP1378940 A2 und DE102006038980 A1 offenbaren Leistungsmodule mit Kühlkörpern, die in Ausparungen eingebrachte und fixierte Kühlrippen aufweisen.

Die Einheit, umfassend ein Leistungsmodul und ein Kühlkörper, wird hier als Leistungsmoduleinheit bezeichnet.

Nachteilig am Stand der Technik ist weiter die Vielzahl von Materialübergängen. Ein Wärmestrom, ausgehend von dem Leistungshalbleiter über die Grundplatte zum Kühlkörper übertragen, wird hierdurch vermindert.

Zur Verbesserung der Wärmeübertragung von dem Leistungshalbleiter zum Kühlkörper schlägt beispielsweise DE 10 2013 207 804 A1 vor, eine Grundplatte auf der einen Seite mit wärmeleitenden Strukturen einstückig auszubilden. Der Leistungshalbleiter wird auf der gegenüberliegenden Seite der Grundplatte befestigt.

Die Größe der wärmeleitenden Strukturen ist allerdings durch die Herstellung begrenzt. Darüber hinaus ist die Herstellung einer solchen Leistungsmoduleinheit aufwendig und daher kostspielig.

Es ist demnach Aufgabe der Erfindung, das Verfahren zur Herstellung einer Leistungsmoduleinheit zu vereinfachen.

Die Aufgabe wird durch eine Leistungsmoduleinheit gemäß Anspruch 1 gelöst. Die Aufgabe wird weiter durch einen Frequenzumrichter oder ein Netzteil gemäß Anspruch 10 gelöst. Die Aufgabe wird darüber hinaus durch ein Verfahren nach Anspruch 11 gelöst.

Vorteilhafte Ausgestaltungen und Weiterbildungen sind Gegenstand der abhängigen Ansprüche.

Der Erfindung liegt die Erkenntnis zu Grunde, dass ein direktes Aufbringen des Substrates mit dem Leistungshalbleiter auf die Grundplatte eine Materialgrenze zwischen der Grundplatte und dem Kühlkörper ersetzt. Vorzugsweise wird das Substrat mit einer Löt-Verbindung auf der Grundplatte des Kühlkörpers befestigt. Die Grundplatte dient somit auf der ersten Seite als Träger des Substrates. Weiter dient die zweite Seite der Grundplatte zur Befestigung der Kühlrippen.

Bei herkömmlichen Kühlkörpern mit Kühlrippen, welche einige Zentimeter lang sein können, führt dieses Verfahren zu Schwierigkeiten, da der gesamte Kühlkörper beispielsweise in einem Ofen auf eine Temperatur von etwa 200 bis etwa 500 Grad Celsius erwärmt werden muss. Eine Erwärmung des gesamten Kühlkörpers ist jedoch energie- und zeitaufwendig. Demnach gründet die Erfindung auf der Einsicht, dass es vorteilhaft ist, lediglich die Grundplatte mit dem Substrat in dem Ofen zu erwärmen und die Kühlrippen nach der Befestigung des Substrates in Aussparungen der Grundplatte zu befestigen. Die Befestigung der Kühlrippen erfolgt vorzugsweise derart, dass die Grundplatte mit dem Substrat nicht verbogen wird. Eine Biegung der Grundplatte könnte das Substrat beschädigen.

Dies wird beispielhaft durch einen trapezförmigen Querschnitt der Aussparung erreicht. Darüber hinaus können die Kühlrippen vorteilhaft in tangentialer Richtung zur ersten Seite in die jeweilige Aussparung aus eingebracht werden.

Vorzugsweise umfasst das Substrat eine Keramik-Schicht, wobei die Keramik-Schicht auf der Oberseite und der Unterseite jeweils, zumindest bereichsweise eine Metall-Schicht aufweist. Die Metall-Schicht umfasst vorzugsweise Kupfer, Silber oder Zinn. Die vorzugsweise bereichsweise aufgetragene Metall-Schicht auf der Oberseite des Substrates dient zur Befestigung des Leistungshalbleiters. Die vorzugsweise auf der Unterseite aufgetragene Metallschicht dient zur Löt-, Press- oder Sinterverbindung des Substrates mit der Grundplatte.

Die Leistungsmoduleinheit weist eine Grundplatte mit zumindest einer Aussparung auf einer ersten Seite auf, wobei in der jeweiligen Aussparung zumindest eine Kühlrippe befestigt ist, wobei die jeweilige Kühlrippe in jeweils eine Aussparung der Grundplatte durch eine zumindest bereichsweise formschlüssig, bereichsweise stoffschlüssig und/oder bereichsweise kraftschlüssig ausgeführte Verbindung befestigt ist, wobei die Grundplatte auf einer zweiten Seite ein Substrat für ein Leistungshalbleiter aufweist, wobei die jeweilige Kühlrippe weist an zumindest einer Seite einen Aufsatz auf, wobei der Aufsatz nach Einbringen der Kühlrippe die erste Seite der Grundplatte berührt.

Die Leistungsmoduleinheit umfasst optional noch ein Gehäuse, welches das Substrat vor Umgebungseinflüssen schützt. Das Substrat dient als Grundlage für Leistungshalbleiter wie ein IGBT oder ein Thyristor. Es können auch mehrere Leistungshalbleiter auf dem Substrat befestigt sein.

Die Aussparung verläuft vorzugsweise entlang der ersten Seite von einem Ende der Grundplatte bis zum anderen Ende der Grundplatte.

Die Aussparung dient vorteilhaft zur Aufnahme von einer oder mehreren Kühlrippen. Die jeweilige Kühlrippe wird vorzugsweise in die Aussparung der Grundplatte dann eingeführt, wenn das Substrat auf der zweiten Seite bereits auf der Grundplatte befestigt ist.

Vorzugsweise umfasst die Leistungsmoduleinheit zusätzlich ein Gehäuse, wobei das Gehäuse die zweite Seite zumindest bereichsweise abdeckt. Das Gehäuse dient zur Abdeckung und somit zum Schutz des Substrates oder des zumindest einen Leistungshalbleiters.

Unter einer stoffschlüssigen Verbindung wird beispielhaft eine Löt-Verbindung, eine Klebeverbindung oder eine Schweißverbindung verstanden.

Die Verbindung der Kühlrippe mit der Grundplatte ist vorzugsweise zumindest bereichsweise formschlüssig ausgeführt. Die formschlüssige Verbindung stellt eine gute thermische Verbindung zwischen der Grundplatte und der jeweiligen Kühlrippe her. Die formschlüssige Verbindung dient demnach zur verbesserten Abführung von Abwärme der Leistungshalbleiter über die Grundplatte auf die Kühlrippen.

Vorzugsweise werden die Kühlrippen durch eine kraftschlüssige Verbindung derart mit der Grundplatte befestigt, dass die Kühlrippen in eine erhitzte Grundplatte eingesetzt werden und mit Abkühlen der Grundplatte eine kraftschlüssige Verbindung eingehen. Alternativ oder zusätzlich können auch die Kühlrippen beim Einbringen gekühlt sein und durch ein Erwärmen auf Raumtemperatur eine kraftschlüssige Verbindung ausbilden.

Die Erfindung offenbart folgende Vorteile:
- Durch eine direkte Verbindung des Substrates mit der Grundplatte und lediglich einem weiteren thermischen Widerstand zu den Kühlrippen kann die Wärme von dem Substrat besonders effizient über die Kühlrippen abgeführt werden.
- Durch die variable Verbindung der Grundplatte mit den Kühlrippen, können Parameter der jeweiligen Kühlrippe wie Länge, Form, Oberflächenbeschaffenheit; gezielt an die Anwendung der Leistungsmoduleinheit angepasst werden.
- Dadurch, dass das Substrat lediglich auf der Grundplatte befestigt ist, kann es mit Hilfe eines Ofens schnell und energiesparend hergestellt werden.

Bei einer vorteilhaften Ausgestaltung der Erfindung ist die jeweilige Kühlrippe durch eine Pressverbindung, eine Klebeverbindung oder eine Löt-Verbindung mit der Grundplatte verbunden.

Alternativ oder zusätzlich kann die jeweilige Kühlrippe mit einer Löt-Verbindung oder einer Klebeverbindung in der Aussparung der Grundplatte befestigt werden.

Durch eine feste Verbindung der jeweiligen Kühlrippe mit der Grundplatte ist die Leistungsmoduleinheit stabil gegen äußere Einflüsse ausgebildet. Zudem ist durch eine feste Verbindung der jeweiligen Kühlrippe mit der Grundplatte eine gute und sichere Wärmeübertragung von dem Leistungshalbleiter auf die Kühlrippen gewährleistet.

Bei einer weiteren vorteilhaften Ausgestaltung der Erfindung weist die Grundplatte Kupfer, Aluminium oder eine Schicht aus Kupfer und eine Schicht aus Aluminium auf.

Vorzugsweise dient Kupfer als Material zur Aufnahme des Substrates, weil es sich gut zum Aufbau einer Löt-Verbindung eignet und ein guter Wärmeleiter ist.

Vorzugsweise dient Aluminium als Material für die Grundplatte, weil Aluminium einerseits ein guter Wärmeleiter ist und darüber hinaus durch seine gute Verformbarkeit für eine formschlüssige Verbindung der Grundplatte mit den Kühlrippen geeignet ist.

Besonders vorteilhaft ist die Grundplatte aus zwei aufeinander fest verbundenen Metallschichten ausgebildet. Eine solche Grundplatte weist angrenzend an die erste Seite eine Aluminiumschicht auf, die auf ihrer Oberseite eine Kupferschicht aufweist. Beide Metallschichten sind beispielhaft durch ein Walzverfahren fest miteinander verbunden. Alternativ können die Schichten auch durch ein Löt-Verfahren, insbesondere mit einem Hochtemperatur-Löt-Verfahren, miteinander verbunden sein.

Eine solche Schicht weist die oben genannten Vorteile auf und ist im Handel erhältlich.

Der Aufsatz dient dazu, das Eindringen der Kühlrippe in die Aussparung derart zu begrenzen, dass eine Bodenseite der Aussparung die Kühlrippe lediglich berührt.

Alternativ oder zusätzlich kann der Aufsatz bereichsweise in die Aussparung hineinragen. Beispielhaft weist die Aussparung an ihren Kanten mit der ersten Seite schräg ausgerichtete Seitenflächen auf. Die Seitenflächen dienen zur Aufnahme der ebenfalls schräg ausgeführten Seitenfläche des Aufsatzes.

Durch den Aufsatz kann eine Belastung der Grundplatte beim Einbringen der jeweiligen Kühlrippe in die Aussparung vermindert werden. Insbesondere die Biegespannung, welche eine Kraft senkrecht zur ersten Seite der Grundplatte induziert, kann wirksam reduziert werden. Mit der Reduktion der Kraft und damit der Biegespannung auf die Grundplatte wird die Verbindung des Substrates mit der Grundplatte einer verminderten Belastung beim Einbringen der Kühlrippen in die Aussparung bewirkt.

Bei einer weiteren vorteilhaften Ausgestaltung der Erfindung weist die jeweilige Kühlrippe Kupfer, Aluminium oder einer Legierung auf.

Die Kühlrippe ist vorzugsweise aus einem Material mit guter Wärmeleitung, insbesondere Aluminium, einer Aluminiumlegierung, Kupfer oder einer Kupferlegierung, ausgebildet.

Durch ein Material mit guter Wärmeleitung kann die Wärme effizient von der Grundplatte abgeführt werden.

Bei einer weiteren vorteilhaften Ausgestaltung der Erfindung ist die Befestigung der Grundplatte mit der jeweiligen Kühlrippe durch Einkerbungen und Aufprägungen verstärkt.

Vorzugsweise weist zumindest ein Teil der Aussparungen der Grundplatte und/oder die Kühlrippen Einkerbungen und/oder Aufprägungen auf. Die Aussparungen können beim Einbringen der Kühlrippe in die jeweilige Aussparung Einkerbungen in die Kühlrippe einprägen. Durch die Einkerbungen wird zumindest bereichsweise eine formschlüssige Verbindung ausgebildet.

Vorzugsweise ragen Aufprägungen der Kühlrippe in Einkerbungen der jeweiligen Aussparung hinein. So ist eine besonders feste Verbindung möglich.

Die Ausprägungen in der jeweiligen Aussparung dienen demnach zur verbesserten Verbindung der Kühlrippen mit der Grundplatte.

Bei einer weiteren vorteilhaften Ausgestaltung der Erfindung ist die Härte des Materials für die Grundplatte und die Härte des Materials für die jeweilige Kühlrippe unterschiedlich.

Vorzugsweise weist die Grundplatte ein Material mit einer größeren Härte als das Material der Kühlrippen auf. So wird das Material der Kühlrippe leicht verformt und eine zumindest bereichsweise formschlüssige Verbindung zwischen der Grundplatte und der Kühlrippe ausgebildet.

Bei der vorstehend ausgeführten Alternative wird vorteilhaft beim Einbringen der Kühlrippe in die jeweilige Aussparung die Kühlrippe und/oder die Innenseite der Aussparung in der Grundplatte leicht verformt. Insbesondere tragen Aufprägungen zu einer Verformung der Kühlrippe und/oder zur Verformung der Grundplatte bei.

Alternativ kann auch das Material der Kühlrippe härter als das Material der Grundpatte ausgebildet sein. Eine solche Ausgestaltung führt vorzugsweise zu einer vereinfachten Herstellung der Leistungsmoduleinheit.

Bei einer weiteren vorteilhaften Ausgestaltung der Erfindung ist die jeweilige Kühlrippe U-förmig, O-förmig oder 8-förmig ausgebildet.

Vorzugsweise weist die Kühlrippe eine Öffnung auf. Die Öffnung dient vorzugsweise zur Durchführung eines Kühlmediums wie ein Luftstrom. Vorzugsweise ist die Öffnung so ausgebildet, dass ein Querschnitt der Kühlrippe innen hohl ist. Vorzugsweise ist der Querschnitt der jeweiligen Kühlrippe demnach 0-förmig ausgebildet.

Vorzugsweise ist die Kühlrippe in der Mitte mit einer Verstärkung, insbesondere einem Materialübergang ausgebildet.

Dieser Materialübergang führt zu einem 8-förmigen Querschnitt der Kühlrippe.

Bei einer weiteren vorteilhaften Ausgestaltung der Erfindung ist ein Querschnitt der jeweiligen Aussparung zur zweiten Seite hin verjüngt, vorzugsweise Trapez-förmig ausgebildet.

Um beim Einbringen der jeweiligen Kühlrippe nur eine minimale Biegespannung auf die Grundplatte zu übertragen, ist die Aussparung nach innen hin verjüngt ausgebildet. Vorzugsweise ist die Aussparung trapezförmig ausgebildet. Gegebenenfalls sind an den Seiten der Innenfläche der jeweiligen Aussparungen Aufprägungen positioniert. Die Aufprägungen dienen vorzugsweise zur Fixierung der Kühlrippe in der Aussparung.

Durch die nach innen verjüngte Aussparung wird vorteilhaft das Substrat der Leistungsmoduleinheit beim Einbringen der jeweiligen Kühlrippe geschont.

Bei einer weiteren vorteilhaften Ausgestaltung der Erfindung sind weitere Kühlrippen zwischen den Kühlrippen positioniert, wobei die jeweilige weitere Kühlrippe und die Kühlrippe nur bereichsweise seitlich überlappen.

Die weiteren Kühlrippen sind vorzugsweise kraftschlüssig mit den Kühlrippen verbunden. Die weiteren Kühlrippen und die Kühlrippen überlappen vorzugsweise jeweils mit einer Breite von 1 Zentimeter bis 2 Zentimeter.

Vorzugsweise sind die Seiten der Kühlrippen zumindest in dem Bereich, in dem die Kühlrippen und die weiteren Kühlrippen jeweils überlappen, mit einer gerippten Struktur ausgebildet. Unter einer gerippten Struktur wird insbesondere verstanden, dass die Seite der jeweiligen Kühlrippe und/oder die Seite der jeweiligen weiteren Kühlrippe Aufprägungen aufweist. Die Aufprägung kann einen dreieckigen Querschnitt aufweisen. Vorzugsweise sind die Aufprägungen jeweils parallel zueinander ausgerichtet. Vorteilhaft sind die Aufprägungen jeweils parallel zur Kante der Kühlrippe ausgerichtet.

Vorzugsweise sind jeweils zwischen den Aufprägungen Einkerbungen positioniert. Vorzugsweise weisen die Einkerbungen einen dreieckigen Querschnitt auf.

Vorzugsweise ragen die Aufprägungen der Kühlrippe in die Einkerbungen der jeweils benachbarten weiteren Kühlrippe hinein.

Durch die Erweiterung der bestehenden Kühlrippen mit weiteren Kühlrippen kann nachträglich die Kühlleistung der Leistungsmoduleinheit vergrößert werden.

Bei einer weiteren vorteilhaften Ausgestaltung der Erfindung ist die Kühlrippe zumindest bereichsweise aus Kohlenstoff, beispielsweise aus Graphit, ausgebildet.

Vorteilhaft kann die Kühlrippe zumindest bereichsweise aus Carbon-Nanotubes ausgebildet sein oder Carbon-Nanotubes umfassen.

Insbesondere Graphit oder Carbon-Nanotubes weisen eine besonders hohe Wärmeleitfähigkeit auf.

Durch die hohe Wärmeleitfähigkeit kann die Kühlung der Grundplatte verbessert werden.

Bei einer weiteren vorteilhaften Ausgestaltung der Erfindung sind Kühlrippen miteinander verbunden.

Die Verbindung der Kühlrippen erfolgt vorteilhaft durch Verbindungselemente. Die Verbindungselemente und die Kühlrippen bilden vorzugsweise eine Einheit. Die Einheit wird vorteilhaft als Ganzes in die Aussparungen der Grundplatte eingebracht werden.

Vorzugsweise sind die Verbindungselemente stoffschlüssig mit den Kühlrippen verbunden.

Vorzugsweise sind die Kühlrippen und die Verbindungselemente einstückig ausgeführt. Vorzugsweise weisen die Verbindungselemente Öffnungen auf. Die Öffnungen dienen vorteilhaft zur Reduktion von Gewicht. Weiter sind die Öffnungen vorzugsweise zur Durchführung eines Kühlmediums, insbesondere eines Kühlluftstroms, ausgebildet.

Durch die Einheit ist eine besonders feste und gleichmäßige Verbindung der Kühlrippen mit der Grundplatte möglich. Überdies kann Wärme von einer Kühlrippe zu einer anderen Kühlrippe übertragen werden.

In einer vorteilhaften Ausgestaltung der Erfindung sind Kühlrippen mit Verbindungselementen zu einer Einheit miteinander verbunden. Vorzugsweise sind die Einheiten derart gestaltet, dass eine Einheit durch eine Steckverbindung, eine Pressverbindung oder eine Klebeverbindung mit einer weiteren Einheit verbindbar ist.

Die Einheit weist vorzugsweise parallel ausgerichtete Kühlrippen auf, wobei Kühlrippen durch die Verbindungselemente miteinander verbunden sind.

Vorzugsweise weisen die Kühlrippen an beiden Enden eine strukturierte Oberfläche, insbesondere eine gerippte Oberfläche, auf. Durch die strukturierte Oberfläche ist eine verbesserte Verbindung der Kühlrippen miteinander möglich, wobei vorzugsweise zur Verbindung eine Kühlrippe zwischen jeweils zwei andere Kühlrippen gesteckt wird. Die strukturierte Oberfläche dient zum verbesserten Zusammenhalt der Kühlrippen untereinander. Durch die Verbindungselemente werden die Kühlrippen miteinander fixiert.

Eine vorteilhafte Anwendung der hier beschriebenen Leistungsmoduleinheit ist Frequenzumrichter oder Netzteil, insbesondere für den industriellen Einsatz.

Vorteilhaft dient ein solcher Frequenzumrichter für mobile Anwendungen wie zumindest teilweise elektrisch angetriebene Fahrzeuge. Weiter vorteilhaft ist die Erfindung bei elektrisch angetriebenen Flugzeugen anwendbar. Zusätzlich ist die Erfindung vorteilhaft für ein Ladegerät einsetzbar.

Vorzugsweise findet die Erfindung bei einem Ladegerät für ein elektrisch angetriebenes Fahrzeug oder Flugzeug Anwendung. Vorteilhaft können die Art, Anzahl, Form und Größe der Kühlrippen nach dem Kühlbedarf der Leistungsmoduleinheit in der jeweiligen Anwendung ausgewählt werden.

Bei dem Verfahren zur Herstellung einer Leistungsmoduleinheit weist die Leistungsmoduleinheit eine Grundplatte mit Aussparungen auf einer ersten Seite auf, umfassend folgende Schritte:
a) Positionieren eines Substrates auf einer zweiten, den Aussparungen gegenüberliegenden, Seite;
b) Erwärmen der Grundplatte und des Substrates, so dass das Substrat, insbesondere durch eine Löt-, Sinter- oder Pressverbindung, auf der ersten Seite der Grundplatte befestigt wird;
c) Einbringen und Befestigen von zumindest einer Kühlrippe in der jeweiligen Aussparung, wobei die Befestigung formschlüssig und/oder kraftschlüssig ausgeführt wird, wobei die jeweilige Kühlrippe weist an zumindest einer Seite einen Aufsatz auf, wobei der Aufsatz nach Einbringen der Kühlrippe die erste Seite der Grundplatte berührt

Optionale und vorteilhafte Schritte bei der Herstellung der Leistungsmoduleinheit sind:
- Befestigen eines Gehäuses an der Grundplatte, wobei das Gehäuse das Substrat und einen Leistungshalbleiter schützt;
- Aufbringen von Kontaktelementen auf einer Metall-Schicht, wobei die Metall-Schicht zur Befestigung des Leistungshalbleiters dient. Das jeweilige Kontaktelement kann auf einer Seite mit dem Gehäuse verbunden sein. Das Kontaktelement dient vorteilhaft zum Anschluss des Leistungshalbleiters mit einer elektrischen Leitung.
- Vorzugsweise erfolgt eine Isolation des Substrates. Eine Isolation erfolgt vorteilhaft durch Beaufschlagen des Substrates mit einem nicht-leitenden Werkstoff auf Polymer-Basis, insbesondere auf Silikon-Basis.

Vorzugsweise erfolgt das Erwärmen der Grundplatte mit dem Substrat in einem Ofen. Das Substrat und die Grundplatte werden auf eine Temperatur zwischen 200 und 500 Grad erwärmt. Die Erwärmung dient zur Ausbildung einer Löt-, Sinter oder Pressverbindung von dem Substrat mit der Grundplatte.

Die Kühlrippen werden vorzugsweise gemeinsam in jeweils für die Kühlrippe vorgesehene Aussparung eingebracht. Hierzu werden die Kühlrippen ausgerichtet und die Grundplatte aufgepresst.

In einer vorteilhaften Ausgestaltung werden die Aussparungen nach der Befestigung des Substrates in die Grundplatte eingebracht.

Vorzugsweise werden die Aussparungen durch eine spanhebende Bearbeitung in die Grundplatte eingebracht. Durch das nachträgliche Einbringen der Aussparung kann die Grundplatte ohne Aussparungen in einem Ofen erwärmt werden. Durch die quaderförmige Ausführung der Grundplatte kann die Grundplatte besonders gleichmäßig erwärmt werden und ist bei einer Pressverbindung der Grundplatte mit dem Substrat besonders stabil ausgebildet.

Zur Ausbildung einer kraftschlüssigen Verbindung kann das Material der Grundplatte und das Material der jeweiligen Kühlrippe derart ausgewählt werden, dass bei einer erwärmten Grundplatte der Querschnitt der Aussparung der Grundplatte vergrößert ist und bei Raumtemperatur um den Teil der Kühlrippe, der sich in der Aussparung befindet, eine kraftschlüssige und/oder formschlüssige Verbindung ausbildet.

Alternativ oder zusätzlich kann auch eine Löt-Verbindung oder eine Klebeverbindung für eine Befestigung der jeweiligen Kühlrippe mit der Grundplatte beitragen.

Durch das vorstehend beschriebene Verfahren zur Herstellung der Leistungsmoduleinheit können die Kühlrippen entsprechend dem jeweiligen Einsatz ausgewählt werden. Gleichzeitig wird bei der Verbindung der Grundplatte mit dem Substrat Zeit eingespart, weil die Kühlrippen nicht mit erwärmt werden müssen. Zudem ist durch das Erwärmen der Grundplatte ohne Kühlrippen eine besonders gleichmäßige Temperaturverteilung möglich, was zu einer verbesserten Löt- oder Sinterverbindung des Substrates mit der Grundplatte führt.

Überdies kann vorteilhaft die Höhe des Ofens besonders niedrig ausgebildet sein.

Bei einer weiteren vorteilhaften Ausgestaltung der Erfindung erfolgt das Erwärmen der Grundplatte mit dem Substrat in einem Ofen.

Die Erwärmung der Grundplatte und des Substrates auf der Grundplatte erfolgt vorzugsweise in einem Durchlaufofen. Durch eine einfache Veränderung der Durchlaufzeit der Grundplatten durch den Ofen kann die notwendige Erwärmung der Grundplatte und des Substrates gut eingestellt werden.

Bei einer weiteren vorteilhaften Ausgestaltung der Erfindung erfolgt das Einbringen der Kühlrippe in die Aussparung nach einem Abkühlen der Grundplatte.

Vorzugsweise wird vor dem Einbringen der Kühlrippe die Grundplatte auf Raumtemperatur abgekühlt. Durch das Abkühlen der Grundplatte kann beim Einbringen einer Kühlrippe ein Verbiegen von Aufprägungen in der Aussparung verhindert werden. Zudem ist bei einer Klebeverbindung der Kühlrippen mit der Grundplatte ein verbesserter Halt möglich.

Bei einer weiteren vorteilhaften Ausgestaltung der Erfindung werden die Kühlrippen entlang der Aussparung in die jeweilige Aussparung eingebracht.

Um das Substrat beim Einbringen der Kühlrippe in die Aussparung zu schonen, sollte die Kraft, die zu einem Biegen der Grundplatte führt, vermieden werden. Da die Grundplatte entlang der tangentialen Richtung zu den Seiten stabiler ist, führt ein Einbringen der zumindest einen Kühlrippe in tangentialer Richtung zu einer geringen Verformung der Grundplatte und somit zu einer geringen Belastung des Substrates.

Bei einer weiteren vorteilhaften Ausgestaltung der Erfindung umfasst die jeweilige Kühlrippe eine Öffnung, wobei ein Pressmittel in die Öffnung der Kühlrippe geführt wird und mit Hilfe des Pressmittels die Kühlrippe in die Aussparung gepresst wird.

Je nach Form des Pressmittels und eines Querschnitts der Kühlrippe kann das Pressmittel zur Ausbildung einer formschlüssigen Verbindung beitragen. Das Pressmittel verformt vorzugsweise das jeweilige Ende der Kühlrippe, so dass das Material der Kühlrippe die Aussparung zumindest bereichsweise ausfüllt.

Als Pressmittel ist ein Stab einsetzbar. Das Pressmittel wird vorzugsweise durch eine Öffnung der Kühlrippe geführt und die Kühlrippe in die Aussparung eingebracht. Durch Verwendung eines Pressmittels, welches in der Umgebung der Aussparung auf die Kühlrippe wirkt, kann ein Verbiegen der Kühlrippe wirksam verhindert werden.

Bei einer weiteren vorteilhaften Ausgestaltung der Erfindung weist die Grundplatte Kupfer, Aluminium oder eine Schicht aus Kupfer und eine Schicht aus Aluminium auf und/oder weist die jeweilige Kühlrippe Kupfer, Aluminium oder einer Legierung auf.

Bei einer weiteren vorteilhaften Ausgestaltung der Erfindung ist der Aufsatz so auf der jeweiligen Seite der Kühlrippe positioniert, dass nach dem Einbringen der Kühlrippe in die Aussparung ein Hohlraum in der Aussparung ausgebildet ist, wobei der Hohlraum zwischen der Seite der Kühlrippe und einer Bodenseite der Aussparung angeordnet ist.

Bei einer weiteren vorteilhaften Ausgestaltung der Erfindung erfolgt das Erwärmen der Grundplatte mit dem Substrat in einem Ofen und/oder erfolgt das Einbringen der Kühlrippe in die Aussparung nach einem Abkühlen der Grundplatte.

Bei einer weiteren vorteilhaften Ausgestaltung der Erfindung werden die Kühlrippen, welche für die Einbringung in die Aussparrungen der Grundplatte vorgesehen sind, in einem Schritt in die jeweils für die Kühlrippe vorgesehene Aussparung eingebracht.

In einer weiteren vorteilhaften Ausführungsform der Erfindung erfolgt das Einbringen der zumindest einen Kühlrippe tangential zur ersten Seite der Grundplatte, wobei die Aussparung einen Querschnitt aufweist, welcher insbesondere trapezförmig ausgebildet ist. Vorzugsweise werden alle Kühlrippen derart in die Grundplatte eingebracht.

In einer weiteren vorteilhaften Ausführungsform der Erfindung wird beim tangentialen Einbringen der zumindest einen Kühlrippe in die Grundplatte die mindestens eine Kühlrippe orthogonal zum Querschnitt der Aussparung in die Aussparung geschoben, so dass insbesondere die Grundplatte nur minimal verformt wird. Vorzugsweise werden alle Kühlrippen derart in die Grundplatte geschoben.

In einer weiteren vorteilhaften Ausführungsform der Erfindung wird die zumindest eine Kühlrippe über eine Seitenfläche der Grundplatte, welche orthogonal zu der Seitenfläche ausgerichtet ist, in die Aussparung eingebracht, insbesondere eingeschoben oder eingezogen.

Die zumindest eine Kühlrippe wird folglich von der Seitenfläche der Grundplatte ausgehend in die Aussparung geschoben oder gezogen, so dass während des Einbringens der zumindest einen Kühlrippe in die Aussparung die Aussparung schrittweise von der zumindest einen Kühlrippe mit Blick auf die erste Seite der Grundplatte überdeckt wird. Vorzugsweise werden alle Kühlrippen derart in die Grundplatte geschoben oder gezogen.

Im Folgenden wird die Erfindung anhand von Figuren näher beschrieben und erläutert. Die in den Figuren gezeigten Ausführungen sind lediglich beispielhaft und schränken die Erfindung nicht ein. Einzelne Merkmale der beispielhaften Ausführungen können zu weiteren Ausführungen der Erfindung kombiniert werden.

### Es zeigen:

- FIG 1: eine beispielhafte Leistungsmoduleinheit, wobei Fig. 1 nicht Teil der Erfindung ist
- FIG 2: ein Ausschnitt einer beispielhaften Leistungsmoduleinheit, wobei Fig. 2 nicht Teil der Erfindung ist
- FIG 3: ein beispielhaftes Verfahren,
- FIG 4: einen möglichen Querschnitt einer Aussparung, wobei Fig. 4 nicht Teil der Erfindung ist
- FIG 5: eine weitere beispielhafte Leistungseinheit, wobei Fig. 5 nicht Teil der Erfindung ist
- FIG 6: einen Ausschnitt einer erfindungsgemäßen Leistungsmoduleinheit,
- FIG 7: einen Ausschnitt einer erfindungsgemäßen Leistungsmoduleinheit sowie
- FIG 8: eine Verbindung zwischen Kühlrippen und weiteren Kühlrippen, wobei Fig. 8 nicht Teil der Erfindung ist.

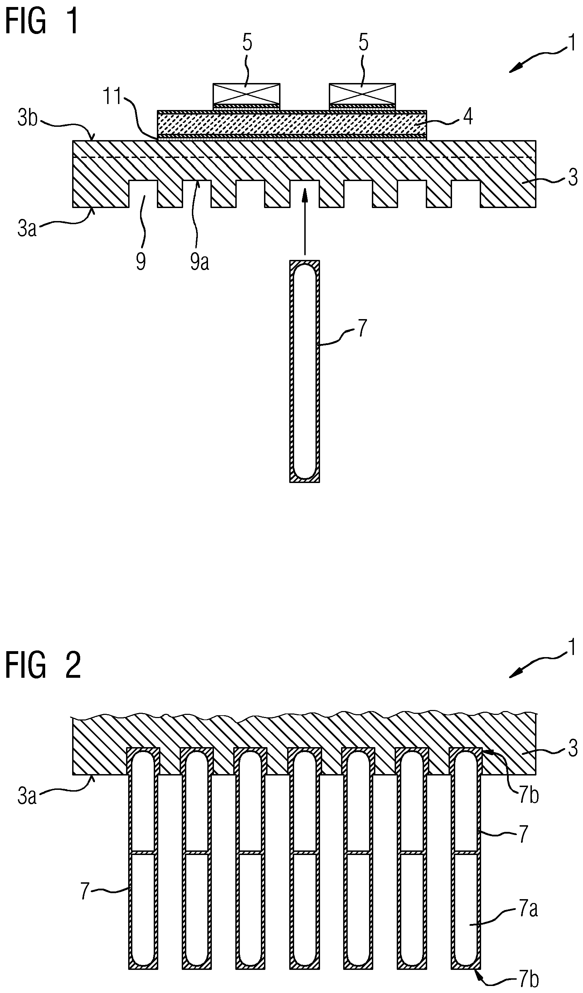

**FIG 1** (nicht Teil der Erfindung) zeigt eine beispielhafte Leistungsmoduleinheit 1. Die Leistungsmoduleinheit 1 umfasst eine Grundplatte 3, wobei die Grundplatte 3 auf einer ersten Seite Aussparungen 9 aufweist. Die Aussparungen 9 dienen jeweils zur Aufnahme zumindest einer Kühlrippe 7. Die Grundplatte weist auf einer zweiten Seite 3b ein Substrat 4 auf. Das Substrat 4 dient als Träger für die Leistungshalbleiter 5. Das Substrat ist vorzugsweise aus einer Keramik hergestellt, wobei das Substrat auf beiden Seiten eine Kupfer-Beschichtung aufweist. Die Kupfer-Beschichtung dient insbesondere als Grundlage einer Löt-Verbindung 11 zur Befestigung des Substrates 4 auf der Grundplatte 3. Die Leistungshalbleiter 5 sind vorzugsweise ebenfalls durch eine Löt-Verbindung 11 mit dem Substrat 4 verbunden. Die Grundplatte 3 ist vorzugsweise aus einer Kupfer- oder einer Aluminium-Legierung ausgebildet. Besonders vorteilhaft ist die Grundplatte 3 im unteren Bereich, angrenzend an die erste Seite 3a, aus Aluminium hergestellt und im oberen Bereich, angrenzend an die zweite Seite 3b, aus Kupfer hergestellt. Grundlage für eine solche Grundplatte 3 ist ein geschichtetes Material. Ein möglicher geschichteter Aufbau ist durch die gestrichelte Linie in der Grundplatte 3 angezeigt. Die jeweilige Kühlrippe wird durch eine formschlüssige und/oder kraftschlüssige Verbindung in die jeweilige Aussparung 9 der Grundplatte 3 mit der Grundplatte 3 befestigt.

**FIG 2** (nicht Teil der Erfindung) zeigt einen Ausschnitt einer beispielhaften Leistungsmoduleinheit 1. Gezeigt ist eine Grundplatte 3 mit einer Mehrzahl von Kühlrippen 7. Die Kühlrippen 7 sind jeweils in einer der Aussparungen 9 der Grundplatte 3 eingebracht. Die gezeigten Kühlrippen 7 weisen jeweils zwei Öffnungen 7a auf. Die Öffnungen 8 sind durch eine Grenze in der Mitte der Kühlrippe 7 voneinander getrennt. Somit wird ein 8-förmiges Profil der Kühlrippe ausgebildet. Durch das 8-förmige Profil kann ein Luftstrom die Kühlrippe besonders effizient kühlen. An dem jeweiligen Ende 7b der Kühlrippe 7 ist die Kühlrippe 7 verstärkt ausgebildet. Eine solche Verstärkung kann durch eine erhöhte Wandstärke der Kühlrippe 7 im Bereich deren jeweiligen Endes 7a erreicht werden. Durch eine Verstärkung der Kühlrippe 7 an ihrem jeweiligen Ende 7a ist eine besonders stabile Verbindung der jeweiligen Kühlrippe 7 mit der Grundplatte 3 möglich.

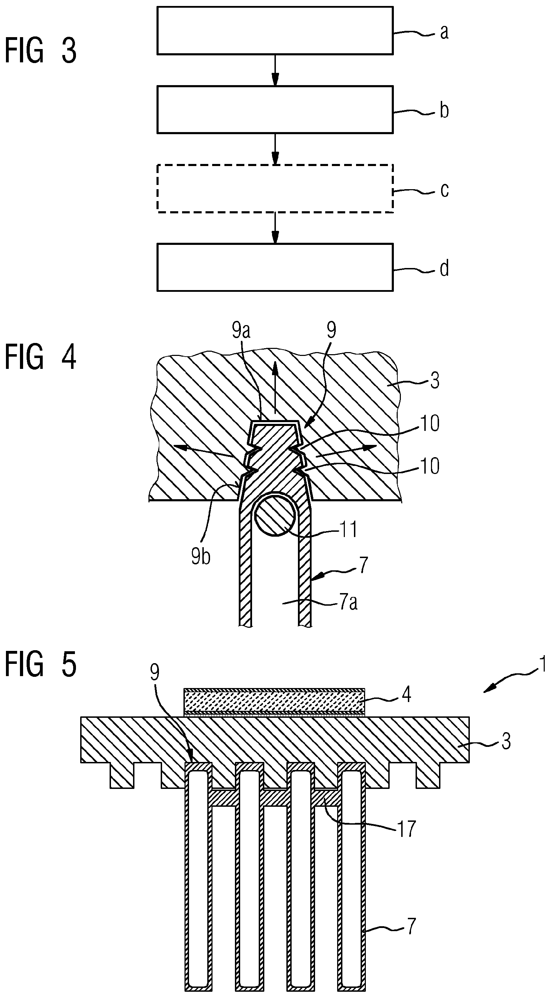

**FIG 3** zeigt ein beispielhaftes Verfahren. Das Verfahren umfasst einen ersten Schritt a, einen zweiten Schritt b, einen dritten, optionalen Schritt c und einen vierten Schritt d.

Im ersten Schritt a wird die jeweilige Aussparung 9 in die Grundplatte 3 eingebracht. Die Aussparung wird durch einen Walzprozess, ein spanhebendes Verfahren wie Fräsen oder durch ein Schmiedeverfahren in die Grundplatte eingeprägt.

In einem zweiten Schritt b wird auf der zweiten Seite 3b der Grundplatte 3 ein Substrat 4 positioniert. Zur Befestigung des Substrates 4 auf der zweiten Seite 3b der Grundplatte 3 wird die Grundplatte mit dem Substrat in einem Ofen auf eine Temperatur von 200 Grad bis 500 Grad Celsius erwärmt. Das Substrat 4 wird in dem zweiten Schritt b durch eine Löt-Verbindung oder eine Sinter-Verbindung mit der zweiten Seite 3b der Grundplatte fest verbunden.

In einem dritten, optionalen, Schritt c wird die Grundplatte mit dem Substrat wieder auf die Raumtemperatur abgekühlt. Je nach Art der Verbindung des Substrates 4 auf der Grundplatte 3 erfolgt die Abkühlung schnell oder langsam.

In einem vierten Schritt d werden die Kühlrippen 7 in die jeweilige Aussparung 9 der Grundplatte eingebracht und befestigt. Das Einbringen der Kühlrippen erfolgt entweder von der Seite, das heißt tangential zur ersten Seite 3a der Grundplatte 3 oder senkrecht hierzu. Beim tangentialen Einbringen der Kühlrippen 7 in die Grundplatte wird die Kühlrippe 7 orthogonal zum Querschnitt 9a der Aussparung 9 in die Aussparung geschoben. Ein solches Einbringen verformt die Grundplatte vorteilhaft nur minimal.

Bei einem senkrechen Einbringen der jeweiligen Kühlrippe 7 in die Aussparung 9 sollte darauf geachtet werden, dass die Kraft, welche auf die Grundplatte 3 wirkt, nicht zu einer Verformung der Grundplatte 3 führt, da ansonsten das Substrat 4 beschädigt werden könnte.

**FIG 4** (nicht Teil der Erfindung) zeigt einen möglichen Querschnitt 9a einer Aussparung 9. Die Aussparung 9 der Grundplatte 3 ist nach innen verjüngt. Zur verbesserten Halterung der Kühlrippe 7 weist die Aussparung 9 an ihrer Innenseite 9b Aufprägungen 10 auf. Die Aufprägungen 10 dienen vorteilhaft zur Ausbildung bereichsweise formschlüssiger Verbindungen zwischen der Grundplatte 3 (hier als Ausschnitt gezeigt) und der Kühlrippe 7.

Der trapezförmige Querschnitt 9a der Aussparung 9 dient bei einem senkrechten Einbringen der Kühlrippe 7 in die Aussparung 9 zur Reduktion der Kraft, welche senkrecht zur ersten Seite 3a oder zweiten Seite 3b der Grundplatte 3 wirkt. Vielmehr wird die Kraft in tangential zur jeweiligen Seite 3a,3b der Grundplatte 3 verlaufende Richtung umgelenkt. Dies ist durch die Pfeile, die von der Aussparung ausgehen, dargestellt.

In der Figur ist überdies ein Pressmittel 11 angedeutet. Das Pressmittel 11 dient zum Einbringen der Kühlrippe 7 in die Aussparung 9. Vorzugsweise ist das Pressmittel 11 als Stab ausgeführt, welcher durch die Öffnung 7a der Kühlrippe geführt wird und die Kühlrippe 7 in die Aussparung 9 der Grundplatte 3 pressen kann. Je nach Form des Pressmittels 11 und eines Querschnitts der Kühlrippe 7 kann das Pressmittel 11 zur Ausbildung einer formschlüssigen Verbindung beitragen. Das Pressmittel 11 verformt vorzugsweise das jeweilige Ende 7a der Kühlrippe 7, so dass das Material der Kühlrippe 7 die Aussparung 9 zumindest bereichsweise ausfüllt.

**FIG 5** (nicht Teil der Erfindung) zeigt eine weitere beispielhafte Leistungsmoduleinheit 1. Die Leistungsmoduleinheit 1 weist einen analogen Aufbau wie die Leistungsmoduleinheit auf, die in FIG 1 gezeigt ist. Im Unterschied zu FIG 1 umfasst die hier gezeigte Leistungsmoduleinheit 1 Kühlrippen 7, die miteinander verbunden sind. Die Verbindung der Kühlrippen erfolgt durch Verbindungselemente 17. Die Verbindungselemente 17 und die Kühlrippen 7 bilden hier eine feste Einheit. Die Einheit aus Kühlrippen 7 und Verbindungselementen 17 wird in die Aussparungen 9 der Grundplatte 3 eingebracht und dort zumindest bereichsweise formschlüssig und/oder kraftschlüssig mit der Grundplatte verbunden.

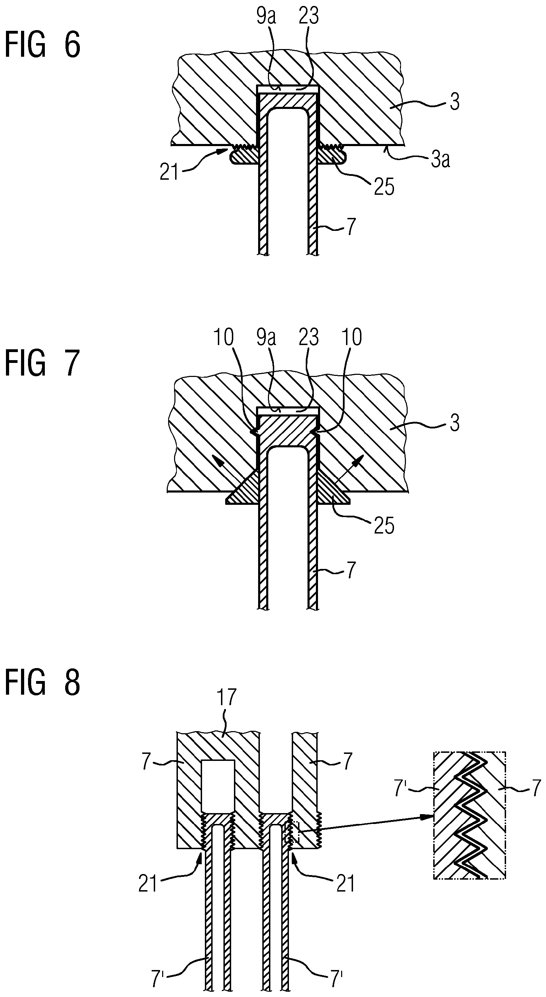

**FIG 6** zeigt einen Ausschnitt einer erfindungsgemäßen Leistungsmoduleinheit 1.

Gezeigt ist ein Ausschnitt der Grundplatte 3 mit der Aussparung 9, wobei in die Aussparung 9 eine Kühlrippe 7 eingebracht worden ist. Die Kühlrippe 7 umfasst einen Aufsatz 25, wobei der Aufsatz 25 so auf der jeweiligen Seite der Kühlrippe 7 positioniert ist, dass nach dem Einbringen der Kühlrippe 7 in die Aussparung 9 ein Hohlraum 23 in der Aussparung ausgebildet ist. Der Hohlraum 23 ist zwischen der Seite der Kühlrippe 7 und der Bodenseite der Aussparung 9 angeordnet. Der Hohlraum 23 ist ausgebildet, weil die Kühlrippe nicht vollständig in die Aussparung 9 eingebracht ist. Zur Ausbildung des Hohlraums 23 ist der jeweilige Aufsatz 25 derart an den Seiten der Kühlrippe 7 positioniert, dass der Aufsatz 25 nach dem Einbringen der Kühlrippe 7 in die Aussparung 9 die erste Seite 31 berührt oder an dieser befestigt ist.

Vorteilhaft liegt der Aufsatz 25 der Kühlrippe 7 auf der ersten Seite 3a der Grundplatte 3 auf. Vorteilhaft erhöht das Aufliegen des Aufsatzes 25 auf der ersten Seite 3a eine flächige Verbindung 21 zwischen Kühlrippe 7 und der Grundplatte. Die flächige Verbindung dient zur Übertragung von Wärme von der Grundplatte 3 auf die Kühlrippe.

Die Höhe des Hohlraums 23 kann auch so klein ausgestaltet sein, dass die Unterseite der Aussparung 9 die Kühlrippe 7 stellenweise berührt.

**FIG 7** zeigt einen Ausschnitt einer erfindungsgemäßen Leistungsmoduleinheit 1.

Analog zu dem Ausschnitt, der in FIG 6 gezeigt ist, weist die Kühlrippe 7 ebenfalls einen Aufsatz 25 auf. Der Aufsatz 25 ist so ausgebildet, dass er eine schräge Auflagefläche aufweist, wobei die schräge Auflagefläche auf einer entsprechenden Schräge bei der Aussparung 9 aufliegt. Beim Einbringen der Kühlrippe 7 in die Aussparung 9 sind die entstehenden Kräfte durch Pfeile gekennzeichnet. Die Kräfte (durch die Pfeile symbolisiert) weisen, in Abhängigkeit der Ausrichtung der schrägen Auflagefläche, eine Kraftkomponente in paralleler Richtung zur ersten Seite der Grundplatte 3 auf.

Durch die schräge Ausrichtung der Auflagefläche wird beim Einbringen der Kühlrippe 7 weniger Kraft auf die Grundplatte 3 zur Ausbildung einer Biegespannung und somit zu einer Belastung des Substrates 4 aufgeprägt. Darüber hinaus ist die Fläche zwischen der Kühlrippe 7 und der Grundplatte 3 vergrößert. Durch die vergrößerte Fläche kann Wärme von der Grundplatte 3 auf die Kühlrippe abgegeben werden.

Zur verbesserten Verbindung der Kühlrippe 7 mit der Grundplatte weist die Innenseite 9a der Aussparung 9 und/oder die Kühlrippe 7 an ihrer Seite eine Aufprägung 10 auf. Die Aufprägung ragt vorzugsweise in eine Einkerbung, wobei die Einkerbung auf jeweils der Seite eingebracht ist, welche die Aufprägung berührt. Vorzugsweise trägt eine solche Aufprägung 10 zur verbesserten Stabilität der Verbindung zwischen der Grundplatte 3 und der Kühlrippe 7 bei.

**FIG 8** (nicht Teil der Erfindung) zeigt eine Verbindung 21 zwischen Kühlrippen 7 und weiteren Kühlrippen 7'. Die Verbindung 21 zwischen den Kühlrippen 7 und den weiteren Kühlrippen 7' kann durch eine Klemmverbindung oder eine kraftschlüssige Verbindung ausgebildet sein. Zum verbesserten Zusammenhalt können die Kühlrippen 7 und/oder die weiteren Kühlrippen 7' im Bereich der Verbindung 21 eine gerippte Struktur aufweisen. Vorzugsweise weisen Kühlrippen 7 und/oder weitere Kühlrippen 7' an ihrer jeweiligen Seite bereichsweise parallel verlaufende Aufprägungen mit dreieckigem Querschnitt auf. Diese Aufprägungen können auch in Einkerbungen ragen, wobei die Einkerbungen einen dreieckigen Querschnitt aufweisen und zwischen den Aufprägungen in die Kühlrippe 7 und/oder die weitere Kühlrippe 7' positioniert sind. Eine solche Verbindung 21 ist in der vergrößerten Darstellung gezeigt. Die gerippte Struktur dient zur stabileren Verbindung der Kühlrippen 7 mit der jeweils weiteren Kühlrippe 7'.

Gezeigt ist ein Verbindungselement 17, wobei das Verbindungselement 17 die Möglichkeit der Verbindung der Kühlrippen 7 (analog zur Ausführung, die in FIG 5 gezeigt ist) offenbart.

Die weiteren Kühlrippen 7', welche in den Zwischenräumen der jeweils parallel ausgerichteten Kühlrippen 7 eingebracht sind, dienen zur weiteren Verbesserung der Kühlung jeweils parallel ausgebildeter Kühlrippen 7 und damit zur verbesserten Kühlung des Substrates 4 auf der Grundplatte 3.

Zusammenfassend betrifft die Erfindung ein Verfahren zur Herstellung einer Leistungsmoduleinheit 1 sowie eine Leistungsmoduleinheit 1. Darüber hinaus betrifft die Erfindung ein Netzteil und einen Frequenzumrichter. Zur Herstellung der Leistungsmoduleinheit 1 wird eine Grundplatte 3 mit Aussparungen 9 versehen. Die Grundplatte wird mit einem Substrat 4, welches den Leistungshalbleiter 5 trägt, verbunden. Nach der Befestigung des Substrates 4 auf der Grundplatte werden die Kühlrippen 7 in die Aussparungen 9 der Grundplatte 3 geführt und formschlüssig und/oder kraftschlüssig befestigt. Durch die Ausführung kann eine Leistungsmoduleinheit 1 bedarfsgerecht mit Kühlrippen 7 ausgebildet werden und gleichzeitig die Herstellung der Leistungsmoduleinheit 1 vereinfacht werden.

## Patentansprüche

1. Leistungsmoduleinheit (1), insbesondere für einen Frequenzumrichter, aufweisend eine Grundplatte (3) mit zumindest einer Aussparung (9) auf einer ersten Seite (3a), wobei in der jeweiligen Aussparung (9) zumindest eine Kühlrippe (7) befestigt ist, wobei die jeweilige Kühlrippe (7) in der jeweiligen Aussparung (9) der Grundplatte (3) durch eine zumindest bereichsweise formschlüssig, bereichsweise stoffschlüssig und/oder bereichsweise kraftschlüssig ausgeführte Verbindung befestigt ist,
**dadurch gekennzeichnet, dass** die Grundplatte (3) auf einer zweiten Seite (3b) ein Substrat (4) für einen Leistungshalbleiter (5) aufweist,
wobei die jeweilige Kühlrippe (7) an zumindest einer Seite einen Aufsatz (25) aufweist, wobei der Aufsatz (25) nach Einbringen der Kühlrippe (7) die erste Seite (3a) der Grundplatte (3) über eine flächige Verbindung (21) berührt.

2. Leistungsmoduleinheit (1) nach Anspruch 1, wobei die jeweilige Kühlrippe (7) durch eine Pressverbindung, eine Klebeverbindung, oder eine Löt-Verbindung mit der Grundplatte (3) verbunden ist.

3. Leistungsmoduleinheit (1) nach Anspruch 1 oder 2, wobei die Grundplatte (3) Kupfer, Aluminium oder eine Schicht aus Kupfer und eine Schicht aus Aluminium aufweist und/oder die jeweilige Kühlrippe (7) Kupfer, Aluminium oder eine Legierung aufweist.

4. Leistungsmoduleinheit (1) nach einem der vorangehenden Ansprüche, wobei der Aufsatz (25) so auf der jeweiligen Seite der Kühlrippe (7) positioniert ist, dass nach dem Einbringen der Kühlrippe (7) in die Aussparung (9) ein Hohlraum (23) in der Aussparung ausgebildet ist,
wobei der Hohlraum (23) zwischen der Seite der Kühlrippe (7) und einer Bodenseite der Aussparung (9) angeordnet.

5. Leistungsmoduleinheit (1) nach einem der vorangehenden Ansprüche, wobei die Befestigung der Grundplatte (3) mit der jeweiligen Kühlrippe (7) durch Einkerbungen und Aufprägungen verstärkt ist.

6. Leistungsmoduleinheit (1) nach einem der vorangehenden Ansprüche, wobei die Härte des Materials für die Grundplatte (3) und die Härte des Materials für die jeweilige Kühlrippe (7) unterschiedlich ist.

7. Leistungsmoduleinheit (1) nach einem der vorangehenden Ansprüche, wobei die jeweilige Kühlrippe (7) U-förmig, O-förmig oder 8-förmig ausgebildet ist.

8. Leistungsmoduleinheit (1) nach einem der vorangehenden Ansprüche, wobei der Querschnitt (9a) der jeweiligen Aussparung (9) zur zweiten Seite (3b) hin verjüngt ist, vorzugsweise trapezförmig ausgebildet ist.

9. Leistungsmoduleinheit (1) nach einem der vorangehenden Ansprüche, wobei weitere Kühlrippen (7') zwischen den Kühlrippen (7) positioniert sind, wobei die jeweilige weitere Kühlrippe (7') und die Kühlrippe (7) nur bereichsweise seitlich überlappen.

10. Frequenzumrichter oder Netzteil, insbesondere für den industriellen Einsatz, aufweisend eine Leistungsmoduleinheit (1) nach dem vorangehenden Anspruch.

11. Verfahren zur Herstellung einer Leistungsmoduleinheit (1), wobei die Leistungsmoduleinheit (1) eine Grundplatte (3) mit Aussparungen (9) auf einer ersten Seite (3a) aufweist, umfassend folgende Schritte:
a) Positionieren eines Substrates (4) auf einer zweiten, den Aussparungen gegenüberliegenden, Seite (3b);
b) Erwärmen der Grundplatte (3) und des Substrates (4), so dass das Substrat, insbesondere durch eine Löt- oder Sinterverbindung (11), auf der ersten Seite (3a) der Grundplatte (3) befestigt wird,
c) Einbringen und befestigen von zumindest einer Kühlrippe (7) in der jeweiligen Aussparung (9), wobei die Befestigung formschlüssig und/oder kraftschlüssig ausgeführt wird,
wobei die jeweilige Kühlrippe (7) an zumindest einer Seite einen Aufsatz (25) aufweist, wobei der Aufsatz (25) nach Einbringen der Kühlrippe (7) die erste Seite (3a) der Grundplatte (3) über eine flächige Verbindung (21) berührt.

12. Verfahren nach Anspruch 11, wobei das Erwärmen der Grundplatte (3) mit dem Substrat (4) in einem Ofen erfolgt und/oder das Einbringen der Kühlrippe (7) in die Aussparung (9) nach einem Abkühlen der Grundplatte (3) erfolgt.

13. Verfahren nach einem der Ansprüche 11 oder 12, wobei die Kühlrippen (7) entlang der Aussparung (9) in die jeweilige Aussparung (9) eingebracht werden.

14. Verfahren nach einem der Ansprüche 11 bis 13, wobei die Kühlrippen (7), welche für die Einbringung in die Aussparrungen (9) der Grundplatte (3) vorgesehen sind, in einem Schritt in die jeweils für die Kühlrippe (7) vorgesehene Aussparung (9) eingebracht werden.

15. Verfahren nach einem der Ansprüche 11 bis 14, wobei das Einbringen der zumindest einen Kühlrippe (7) tangential zur ersten Seite (3a) der Grundplatte (3) erfolgt, wobei die Aussparung (9) einen Querschnitt (9a) aufweist, welcher insbesondere trapezförmig ausgebildet ist.

16. Verfahren nach Anspruch 15, wobei beim tangentialen Einbringen der zumindest einen Kühlrippe (7) in die Grundplatte (3) die zumindest eine Kühlrippe (7) orthogonal zum Querschnitt (9a) der Aussparung (9) in die Aussparung (9) geschoben wird, so dass insbesondere die Grundplatte (3) nur minimal verformt wird.

17. Verfahren nach einem der Ansprüche 11 bis 16, wobei die zumindest eine Kühlrippe (7) über eine Seitenfläche der Grundplatte (3), welche orthogonal zu der Seitenfläche (3a) ausgerichtet ist, in die Aussparung (9) eingebracht, insbesondere eingeschoben oder eingezogen, wird.

18. Verfahren nach einem der Ansprüche 11 bis 14, wobei die jeweilige Kühlrippe (7) eine Öffnung (7a) umfasst, wobei ein Pressmittel in die Öffnung (7a) der Kühlrippe (7) geführt wird und mit Hilfe des Pressmittels die Kühlrippe (7) in die Aussparung (9) gepresst wird.

## Claims

1. Power module unit (1), in particular for a frequency converter, having a base plate (3) with at least one recess (9) on a first side (3a), wherein at least one cooling fin (7) is fastened in the respective recess (9), wherein the respective cooling fin (7) is fastened in the respective recess (9) of the base plate (3) by a connection that is designed with a positive fit at least in regions, a material fit in regions and/or a non-positive fit in regions, **characterised in that** the base plate (3) has a substrate (4) for a power semiconductor (5) on a second side (3b),
wherein the respective cooling fin (7) has an attachment (25) on at least one side, wherein the attachment (25) touches the first side (3a) of the base plate (3) via a planar connection (21) once the cooling fin (7) has been introduced.

2. Power module unit (1) according to claim 1, wherein the respective cooling fin (7) is connected to the base plate (3) by way of a pressed connection, an adhesive connection or a soldered connection.

3. Power module unit (1) according to claim 1 or 2, wherein the base plate (3) has copper, aluminium or a layer of copper and a layer of aluminium and/or the respective cooling fin (7) has copper, aluminium or an alloy.

4. Power module unit (1) according to one of the preceding claims, wherein the attachment (25) is positioned on the respective side of the cooling fin (7) such that, once the cooling fin (7) has been introduced into the recess (9), a cavity (23) is embodied in the recess,
wherein the cavity (23) is arranged between the side of the cooling fin (7) and a bottom side of the recess (9).

5. Power module unit (1) according to one of the preceding claims, wherein the fastening of the base plate (3) to the respective cooling fin (7) is reinforced by indentations and notches.

6. Power module unit (1) according to one of the preceding claims, wherein the hardness of the material for the base plate (3) and the hardness of the material for the respective cooling fin (7) are different.

7. Power module unit (1) according to one of the preceding claims, wherein the respective cooling fin (7) is embodied in a U-shaped, O-shaped or 8-shaped manner.

8. Power module unit (1) according to one of the preceding claims, wherein the cross-section (9a) of the respective recess (9) is tapered toward the second side (3b), preferably is embodied in a trapezoid-shaped manner.

9. Power module unit (1) according to one of the preceding claims, wherein further cooling fins (7') are positioned between the cooling fins (7), wherein the respective further cooling fin (7') and the cooling fin (7) only overlap at the sides in regions.

10. Frequency converter or power supply, in particular for industrial use, having a power module unit (1) according to the preceding claim.

11. Method for producing a power module unit (1), wherein the power module unit (1) has a base plate (3) with recesses (9) on a first side (3a), comprising the following steps:
a) positioning a substrate (4) on a second side (3b) opposite the recesses;
b) heating the base plate (3) and the substrate (4), so that the substrate is fastened to the first side (3a) of the base plate (3), in particular by way of a soldered or sintered connection (11);
c) introducing and fastening at least one cooling fin (7) in the respective recess (9), wherein the fastening is designed with a positive fit and/or non-positive fit,
wherein the respective cooling fin (7) has an attachment (25) on at least one side, wherein the attachment (25) touches the first side (3a) of the base plate (3) via a planar connection (21) once the cooling fin (7) has been introduced.

12. Method according to claim 11, wherein the heating of the base plate (3) with the substrate (4) takes place in a furnace and/or the introduction of the cooling fin (7) into the recess (9) takes place after the base plate (3) has cooled down.

13. Method according to one of claims 11 or 12, wherein the cooling fins (7) are introduced into the respective recess (9) along the recess (9).

14. Method according to one of claims 11 to 13, wherein the cooling fins (7) that are provided for introduction into the recesses (9) of the base plate (3) are, in one step, introduced into the recess (9) provided for the cooling fin (7) in each case.

15. Method according to one of claims 11 to 14, wherein the introduction of the at least one cooling fin (7) takes place tangentially in relation to the first side (3a) of the base plate (3), wherein the recess (9) has a cross-section (9a) that in particular is embodied in a trapezoid-shaped manner.

16. Method according to claim 15, wherein, when introducing the at least one cooling fin (7) into the base plate (3) tangentially, the at least one cooling fin (7) is slid into the recess (9) orthogonally in relation to the cross-section (9a) of the recess (9), so that in particular the base plate (3) is only minimally deformed.

17. Method according to one of claims 11 to 16, wherein the at least one cooling fin (7) is introduced into the recess (9), in particular slid in or drawn in, via a side area of the base plate (3) which is oriented orthogonally in relation to the side area (3a).

18. Method according to one of claims 11 to 14, wherein the respective cooling fin (7) comprises an opening (7a), wherein a pressing means is guided into the opening (7a) of the cooling fin (7) and the cooling fin (7) is pressed into the recess (9) with the aid of the pressing means.

## Revendications

1. Unité (1) de module de puissance, en particulier pour un convertisseur de fréquence, comportant une embase (3) ayant au moins un évidement (9) sur une première face (3a), dans laquelle au moins une ailette (7) de refroidissement est fixée dans l'évidement (9) respectif, dans laquelle l'ailette (7) de refroidissement respective est fixée dans l'évidement (9) respectif de l'embase (3) par un assemblage, au moins par endroits à complémentarité de forme, par endroits à coopération de matière et/ou par endroits à coopération de force,
**caractérisée en ce que** l'embase (3) a, sur une deuxième face (3b), un substrat (4) pour un semiconducteur (5) de puissance,
dans laquelle l'ailette (7) respective de refroidissement a, au moins d'un côté, une garniture (25), dans laquelle la garniture (25) touche, après l'introduction de l'ailette (7) de refroidissement, la première face (3a) de l'embase (3) par une liaison (21) en surface.

2. Unité (1) de module de puissance suivant la revendication 1, dans laquelle l'ailette (7) respective de refroidissement est assemblée par emmanchement, par collage, par brasage à l'embase (3).

3. Unité (1) de module de puissance suivant la revendication 1 ou 2, dans laquelle l'embase (3) a du cuivre, de l'aluminium ou une couche de cuivre et une couche d'aluminium et/ou l'ailette (7) respective de refroidissement a du cuivre, de l'aluminium ou un alliage.

4. Unité (1) de module de puissance suivant l'une des revendications précédentes, dans laquelle la garniture (25) est mise en position sur la face respective de l'ailette (7) de refroidissement, de manière à former, après l'introduction de l'ailette (7) de refroidissement dans l'évidement (9), un espace (23) vide dans l'évidement,
dans laquelle l'espace (23) vide est disposé entre la face de l'ailette (7) de refroidissement et une face de fond de l'évidement (9).

5. Unité (1) de module de puissance suivant l'une des revendications précédentes, dans laquelle la fixation de l'embase (3) à l'ailette (7) respective de refroidissement est renforcée par des encochages et des empreintes.

6. Unité (1) de module de puissance suivant l'une des revendications précédentes, dans laquelle la dureté du matériau pour l'embase (3) et la dureté du matériau pour l'ailette (7) respective de refroidissement sont différentes.

7. Unité (1) de module de puissance suivant l'une des revendications précédentes, dans laquelle l'ailette (7) respective de refroidissement est en forme de U, en forme de O ou en forme de 8.

8. Unité (1) de module de puissance suivant l'une des revendications précédentes, dans laquelle la section (9a) transversale de l'évidement (9) respective se rétrécit vers le deuxième côté (3b) en étant constituée, de préférence en forme de trapèze.

9. Unité (1) de module de puissance suivant l'une des revendications précédentes, dans laquelle d'autres ailettes (7') de refroidissement sont mises en position entre les ailettes (7) de refroidissement, dans laquelle les autres ailettes (7') respectives de refroidissement et les ailettes (7) de refroidissement se recouvrent latéralement seulement par endroits.

10. Convertisseur de fréquence ou bloc d'alimentation, en particulier pour l'utilisation dans l'industrie, comportant une unité (1) de module de puissance suivant la revendication précédente.

11. Procédé de fabrication d'une unité (1) de module de puissance, dans lequel l'unité (1) de module de puissance a une embase (3) ayant des évidements (9) sur une première face (3a), comprenant les stades suivants :
a) mise en position d'un substrat (4) sur une deuxième face (3b) opposée aux évidements ;
b) chauffage de l'embase (3) et du substrat (4), de manière à ce que le substrat soit fixé, en particulier par un brasage ou un frittage (11), sur la première face (3a) de l'embase (3),
c) introduction et fixation d'au moins une ailette (7) de refroidissement dans l'évidement (9) respectif, dans lequel la fixation s'effectue à complémentarité de forme et/ou à coopération de force,
dans lequel l'ailette (7) respective de refroidissement a, au moins d'un côté, une garniture (25), dans lequel la garniture (25) touche, après l'introduction de l'ailette (7) de refroidissement, la première face (3a) de l'embase (3) par une liaison (21) en surface.

12. Procédé suivant la revendication 11, dans lequel le chauffage de l'embase (3) avec le substrat (4) a lieu dans un four et/ou l'introduction de l'ailette (7) de refroidissement dans l'évidement (9) a lieu après un refroidissement de l'embase (3).

13. Procédé suivant la revendication 11 ou 12, dans lequel on introduit les ailettes (7) de refroidissement le long de l'évidement (9) dans l'évidement (9) respectif.

14. Procédé suivant l'une des revendications 11 à 13, dans lequel on introduit les ailettes (7) de refroidissement, qui sont prévues pour l'introduction dans les évidements (9) de l'embase (3), en un stade dans l'évidement (9) prévu respectivement pour l'ailette (7) de refroidissement.

15. Procédé suivant l'une des revendications 11 à 14, dans lequel l'introduction de la au moins une ailette (7) de refroidissement s'effectue tangentiellement à la première face (3a) de l'embase (3), dans lequel l'évidement (9) a une section (9a) transversale, qui est constituée en particulier en forme de trapèze.

16. Procédé suivant la revendication 15, dans lequel, lors de l'introduction tangentielle de la au moins une ailette (7) de refroidissement dans l'embase (3), on déplace, dans l'évidement (9), la au moins une ailette (7) de refroidissement orthogonalement à la section (9a) transversale de l'évidement (9), de manière à ne la déformer, en particulier l'embase (3) qu'au minimum.

17. Procédé suivant l'une des revendications 11 à 16, dans lequel on introduit, en particulier on glisse ou on tire, dans l'évidement (9), l'ailette (7) de refroidissement sur une surface latérale de l'embase (3), qui est dirigée orthogonalement à la surface (3a) latérale.

18. Procédé suivant l'une des revendications 11 à 14, dans lequel l'ailette (7) respective de refroidissement comprend une ouverture (7a), dans lequel on fait passer un moyen de pression dans l'ouverture (7a) de l'ailette (7) de refroidissement et, à l'aide du moyen de pression, on presse l'ailette (7) de refroidissement dans l'évidement (9).
